# FASCICULE DE BREVET EUROPEEN

(11) **EP 4 175 448 B1**
(45) Date de publication et mention de la délivrance du brevet: **08.05.2024**
(21) Numéro de dépôt: 22203636.0
(22) Date de dépôt: 25.10.2022
(51) Int. Cl.: H10N 70/20, H10B 53/30, H10B 63/00

(54) **PROCEDE DE CO-FABRICATION D'UNE MEMOIRE FERROELECTRIQUE ET D'UNE MEMOIRE RESISTIVE OXRAM ET DISPOSITIF CO-INTEGRANT UNE MEMOIRE FERROELECTRIQUE ET UNE MEMOIRE RESISTIVE OXRAM**
VERFAHREN ZUR CO-HERSTELLUNG EINES FERROELEKTRISCHEN SPEICHERS UND EINES RESISTIVEN OXRAM-SPEICHERS UND VORRICHTUNG MIT EINEM FERROELEKTRISCHEN SPEICHER UND EINEM RESISTIVEN OXRAM-SPEICHER
METHOD FOR CO-FABRICATING A FERROELECTRIC MEMORY AND AN OXRAM RESISTIVE MEMORY AND DEVICE CO-INTEGRATING A FERROELECTRIC MEMORY AND AN OXRAM RESISTIVE MEMORY

(30) Priorité: 02.11.2021 FR 2111616
(43) Date de publication de la demande: 03.05.2023
(73) Titulaire: Commissariat à l'Energie Atomique et aux Energies Alternatives, 75015 Paris (FR)
(72) Inventeur: GRENOUILLET, Laurent, 38054 Grenoble Cedex 09 (FR); COIGNUS, Jean, 38054 Grenoble Cedex 09 (FR); VIANELLO, Elisa, 38054 Grenoble Cedex 09 (FR)
(74) Mandataire: Cabinet Camus Lebkiri

(56) Documents cités:
- FR-A1- 3 090 196
- FR-A1- 3 101 219
- US-A1- 2019 044 064

## Description

### DOMAINE TECHNIQUE DE L'INVENTION

La présente invention concerne la fabrication de mémoires et plus particulièrement la co-fabrication d'une mémoire ferroélectrique FeRAM et d'une mémoire résistive OxRAM, chacune des deux mémoires ayant une couche de matériau actif à base de dioxyde d'hafnium. La présente invention concerne également un dispositif co-intégrant une mémoire OxRAM et une mémoire FeRAM.

### ARRIERE-PLAN TECHNOLOGIQUE DE L'INVENTION

Les développements liés à l'intelligence artificielle (IA) ont longtemps été cantonnés à la partie logicielle. Pourtant, l'IA trouve également de nombreuses applications dans l'électronique embarquée et il n'est plus possible de compter exclusivement sur le cloud pour les calculs basés sur l'IA. L'arrivée de l'IA embarquée, et le besoin de traitement d'algorithmes directement dans les composants, pose, plus que jamais, la question du matériel. L'lA aura alors besoin d'être traité en local, au coeur même des composants. Pour ce faire, l'utilisation de certaines mémoires microélectroniques s'avère une solution particulièrement prometteuse. Toutefois, les systèmes basés sur l'IA sont très consommateurs de données et nécessitent donc une grande quantité de mémoires sur une même puce pour pouvoir stocker les états du réseau et les paramètres. En outre, plus que les calculs en eux-mêmes, ce sont les transferts de données entre les processeurs et les mémoires qui sont très couteux en énergie. C'est pourquoi, une tendance consiste à utiliser des mémoires à la fois petites et rapides avec une dissipation en énergie liée à leur lecture et à leur écriture qui soit la plus limitée possible.

Tous les réseaux de neurones utilisés en IA requièrent au moins deux phases :
- Une première phase dite d'apprentissage et d'entraînement qui consiste à optimiser un ensemble de paramètres ou poids d'un modèle à partir d'un ensemble de données ; cette première phase nécessite un grand nombre d'opérations d'écriture dans les mémoires qui doivent donc présenter une forte endurance en écriture.
- Une seconde phase dite d'inférence qui consiste à proposer un ensemble de données test au modèle entraîné et à attendre une prédiction ; ce cas, à l'inverse du précédent, nécessite un grand nombre d'opérations de lecture dans les mémoires qui doivent donc présenter une très bonne endurance en lecture.

Il existe différents types de mémoires susceptibles de répondre partiellement aux exigences évoquées ci-dessus.

Ainsi, les mémoires ferroélectriques ou mémoires FeRAM ont pour principales qualités d'être non volatiles, c'est-à-dire de conserver l'information stockée même quand la tension est coupée, de consommer peu d'énergie, d'avoir des temps d'écriture et de lecture faibles par rapport à d'autres types de mémoires non volatiles comme les mémoires FLASH, de pouvoir être intégrées sur des puces de façon massive avec des faibles tensions d'utilisation et de posséder une faible latence en accessibilité et une bonne immunité aux radiations. En outre, ce type de mémoire présente une très grande endurance en écriture pouvant être supérieure à 10¹⁰ cycles.

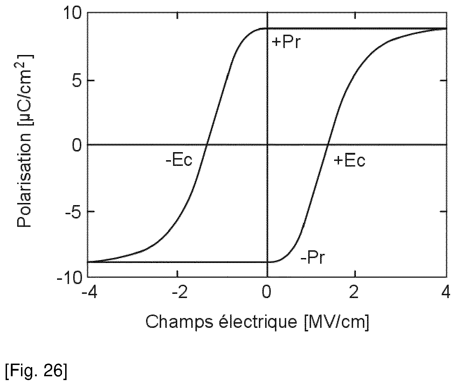

Les mémoires ferroélectriques sont des mémoires de type capacitif présentant deux états de polarisation rémanente +Pr et -Pr. La [Fig 25] illustre le fonctionnement des mémoires ferroélectriques. Ce dernier est basé sur les propriétés ferroélectriques de leur matériau actif placé entre deux électrodes. Par l'application d'une différence de potentiels entre les deux électrodes créant un champ électrique d'une valeur supérieure au champ coercitif positif +Ec, la mémoire ferroélectrique est placée dans un état de polarisation rémanente haute +Pr et par l'application d'une différence de potentiels créant un champ électrique d'une valeur inférieure au champ coercitif négatif -Ec, la mémoire ferroélectrique est placée dans un état de polarisation rémanente basse -Pr. L'état de polarisation rémanente haute +Pr correspond alors à l'état logique binaire '0' et l'état de polarisation rémanente basse -Pr à l'état logique binaire '1', ce qui permet le stockage de l'information. On notera que lorsqu'on arrête l'application de la différence de potentiels, l'état de polarisation rémanente demeure : ceci explique le caractère non volatil des mémoires ferroélectriques. S'agissant de la lecture d'une mémoire ferroélectrique, on ne sait pas a priori dans quel état de polarisation se trouve la mémoire. Donc, pour la lecture, on suppose qu'on est dans un état donné et on va venir appliquer une tension, par exemple positive, au-delà de la tension créant un champ électrique d'une valeur supérieure au champ coercitif positif +Ec : si la mémoire était déjà dans l'état de polarisation rémanente haute +Pr, on ne va pas changer cet état de polarisation et aucun pic de courant ne sera observé (ou un très faible pic de courant sera observé). A l'inverse, si la mémoire était dans l'état de polarisation rémanente basse -Pr, on va observer un pic de courant beaucoup plus important. La conséquence de cette opération de lecture est qu'elle est destructrice de l'état de polarisation. On conçoit dès lors aisément que si les mémoires ferroélectriques répondent au critère d'écriture massive nécessaire à la phase d'apprentissage et d'entraînement, elles ne sont en revanche pas adaptées à la phase d'inférence nécessitant une très bonne endurance en lecture.

On connait un autre type de mémoires dites résistives telles que les mémoires OxRAM pour « Oxide Resistive RAM ». Ces mémoires peuvent présenter au moins deux états résistifs, correspondant à un état fortement résistif (état « HRS » pour « High Resistance State ») et à un état faiblement résistif (état « LRS » pour « Low Resistance State »), sous l'application d'une tension.

Les mémoires OxRAM ont pour principales qualités d'être non volatiles, c'est-à-dire de conserver l'information stockée même quand la tension est coupée, d'avoir des temps d'écriture et de lecture faibles par rapport à d'autres types de mémoires non volatiles comme les mémoires FLASH, de pouvoir être intégrées sur des puces de façon massive, et de posséder une faible latence en accessibilité et une bonne immunité aux radiations et en température. Elles semblent donc de bonnes candidates pour des applications IA. Toutefois, leur endurance en écriture et effacement est assez limitée (de l'ordre de 10⁵ cycles), les rendant ainsi peu efficaces durant la phase d'apprentissage et d'entraînement.

Les mémoires OxRAM présentent une structure M-I-M (Métal-Isolant-Métal) comprenant un matériau actif de résistance électrique variable, en général un oxyde de métal de transition (ex. WOs, HfO₂, Ta₂O₅, TiO₂...), disposé entre deux électrodes métalliques. Le passage de l'état « HRS » à l'état « LRS » est gouverné par la formation et la rupture d'un filament conducteur entre les deux électrodes. Ce filament conducteur se créé grâce à la présence de lacunes d'oxygène présentes dans la couche active de la mémoire. En modifiant les potentiels appliqués aux électrodes, il est possible de modifier la répartition du filament, et de modifier ainsi la conduction électrique entre les deux électrodes. Dans la couche active, le filament électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé aboutissant à l'état LRS, et de RESET aboutissant à l'état HRS, lorsque le filament est rompu à nouveau par application respective d'une tension de SET, V_{SET} ou de RESET, V_{RESET} aux bornes des électrodes). La fabrication d'une mémoire filamentaire comprend une étape dite de « forming », au cours de laquelle le filament est formé pour la première fois dans la couche active, initialement dépourvue de filament. La couche active est en effet initialement complètement isolante électriquement. Lors de l'étape de « forming » initial, un filament électriquement conducteur est formé dans la couche active, en réalisant une sorte de claquage contrôlé de cette couche. Le filament ainsi formé s'étend alors de part en part à travers la couche active, en reliant électriquement l'électrode inférieure et l'électrode supérieure. Pour réaliser cette étape de forming, on peut par exemple appliquer une tension électrique entre l'électrode inférieure et l'électrode supérieure de la cellule mémoire considérée, puis augmenter progressivement la valeur de cette tension jusqu'à une tension seuil, appelée tension de forming V_{forming}, au-delà de laquelle un claquage de la couche active est obtenu. Après cette étape de « forming », la cellule mémoire est prête à l'usage. Le filament conducteur peut alors être rompu, puis reformé, puis rompu à nouveau et ainsi de suite, à une valeur de tension inférieure à la tension de forming V_{forming}.

On comprend à la lecture de ce qui précède que ni les mémoires ferroélectriques ni les mémoires OxRAM ne répondent totalement aux exigences des systèmes basés sur l'IA du fait de limitation soit en lecture (pour les FeRAM) soit en écriture pour les OxRAM.

Même si la demande de brevet FR3090196 ne concerne pas explicitement les applications lA, elle décrit la co-intégration sur une même puce d'une mémoire OxRAM et d'une mémoire FeRAM permettant ainsi d'allier les avantages en écriture et en lecture de l'une et l'autre des mémoires. Cette co-intégration tire parti du fait qu'un même matériau actif, le HfO2, est utilisé pour la couche active de l'OxRAM et la FeRAM.

Le procédé de fabrication décrit dans la demande de brevet FR3090196 permettant d'arriver à cette co-intégration est toutefois complexe à mettre en oeuvre dans la mesure où il nécessite un niveau de masquage pour différencier le dopage de la couche active utilisée pour la mémoire FeRAM de celui de la couche active utilisée pour l'OxRAM. Le procédé implique par ailleurs l'utilisation d'un recuit laser sub-microseconde permettant de diminuer le temps de chauffage du matériau actif dopé et assurant la cristallisation adéquate du dioxyde d'hafnium dans la forme lui conférant des propriétés ferroélectriques sans surchauffer les couches sous-jacentes. En outre, l'efficacité électrique de l'OxRAM obtenue par ce procédé n'est pas entièrement satisfaisante.

### RESUME DE L'INVENTION

L'invention offre une solution aux problèmes évoqués précédemment, en permettant de fabriquer plus facilement une mémoire ferroélectrique co-intégrée avec une mémoire résistive OxRAM tout en préservant des propriétés efficaces des mémoires FeRAM et OxRAM.

Pour ce faire, l'invention a notamment pour objet un procédé de co-fabrication d'une mémoire ferroélectrique comportant une première électrode, une deuxième électrode et une couche de matériau actif à base de dioxyde d'hafnium disposée entre la première électrode et la deuxième électrode et d'une mémoire résistive OxRAM comportant une première électrode, une deuxième électrode et une couche de matériau actif à base de dioxyde d'hafnium HfO₂ disposée entre la première électrode et la deuxième électrode, le procédé de co-fabrication comportant les étapes suivantes :
- Une étape de dépôt d'une couche de première électrode réalisée de manière identique pour la zone destinée à former la mémoire résistive OxRAM et la zone destinée à former la mémoire ferroélectrique ;
- Une étape de dépôt d'une couche de matériau actif à base de dioxyde d'hafnium réalisée de manière identique pour la zone destinée à former la mémoire résistive OxRAM et la zone destinée à former la mémoire ferroélectrique ;
- Une étape de dépôt d'une première couche conductrice réalisée de manière identique pour la zone destinée à former la mémoire résistive OxRAM et la zone destinée à former la mémoire ferroélectrique ;
- Une étape de réalisation d'un masque au niveau de la zone de la première couche conductrice destinée à former la mémoire ferroélectrique en laissant libre la zone de la première couche conductrice destinée à former la mémoire résistive OxRAM ;
- Une étape de retrait de la première couche conductrice au niveau de la zone de la première couche conductrice destinée à former la mémoire résistive OxRAM, la zone de la première couche conductrice destinée à former la mémoire ferroélectrique étant protégée par le masque ;
- Une étape de retrait du masque au niveau de la zone de la première couche conductrice destinée à former la mémoire ferroélectrique ;
- Une étape de dépôt d'une seconde couche conductrice, ladite seconde couche conductrice étant en contact avec la première couche conductrice au niveau de la zone de la première couche conductrice destinée à former la mémoire ferroélectrique et en contact avec la couche de matériau actif au niveau de la zone de la première couche conductrice destinée à former la mémoire résistive OxRAM, le matériau de la seconde couche conductrice étant choisi pour créer des lacunes d'oxygène dans la couche active de l'OxRAM lorsque la seconde couche conductrice est en contact avec la couche active de l'OxRAM ;
- Une étape de dépôt d'une troisième couche conductrice réalisée de manière identique pour la zone destinée à former la mémoire résistive OxRAM et la zone destinée à former la mémoire ferroélectrique, ladite troisième couche conductrice étant en contact avec la seconde couche conductrice.

Grâce à l'invention, on s'affranchit, contrairement au cas de la demande de brevet FR3090196, d'un masquage supplémentaire permettant d'obtenir des dopages différents dans les couches actives respectives de la mémoire FeRAM et de la mémoire OxRAM. De façon surprenante, les inventeurs se sont en effet rendu compte qu'une couche active identique pour les deux mémoires permettait d'obtenir à la fois l'effet ferroélectrique dans la FeRAM et l'effet mémoire résistive dans l'OxRAM (versus la demande FR3090196 où la couche active de la mémoire OxRAM était beaucoup plus dopée que celle de la mémoire ferroélectrique). Ainsi, le dopage de la couche active en dioxyde d'hafnium nécessaire à la FeRAM, est également suffisant pour le fonctionnement résistif de l'OxRAM. Le même raisonnement vaut pour une couche active formée par un alliage à base de dioxyde d'hafnium, comme par exemple du HfZrO2 : dans le cas du HfZrO₂, l'alliage ternaire HfZrO₂ ne nécessite nécessairement pas de dopage de la couche active mais cette dernière est identique pour l'OxRAM et la FeRAM. De façon générale, on entend par couche de matériau actif à base de dioxyde d'hafnium soit une couche d'HfO₂ dopée soit un alliage à base de dioxyde d'hafnium tel que du HfZrO₂ non nécessairement dopé.

Pour ce faire, le procédé selon l'invention utilise avantageusement une modification de l'électrode supérieure qui sera différente pour l'OxRAM et pour la FeRAM. En effet, selon le procédé de l'invention, l'électrode supérieure sera formée respectivement :
- Par une bicouche formée par la seconde couche conductrice et la troisième couche conductrice pour l'OxRAM
- Par une tri-couche formée par la première couche conductrice, la deuxième couche conductrice et la troisième couche conductrice pour la FeRAM.

La seconde couche conductrice est en contact direct avec la couche active à base de dioxyde d'hafnium pour l'OxRAM et présente la particularité d'être une couche de type « Oxygen scavening layer », c'est-à-dire une couche pour créer des lacunes d'oxygène dans la couche active à base de dioxyde d'hafnium de l'OxRAM lorsque cette seconde couche conductrice est en contact avec la couche active de l'OxRAM. Il peut par exemple s'agir d'une couche en titane Ti ou en hafnium Hf. A l'inverse, la couche active côté FeRAM est en contact avec la première couche conductrice qui n'est pas une couche créant des lacunes d'oxygène, par exemple, une couche en TiN, sur laquelle est déposée la seconde couche conductrice. En procédant de la sorte, on crée des lacunes d'oxygène dans la couche à base de dioxyde d'hafnium de l'OxRAM sans en créer dans la couche à base de dioxyde d'hafnium de la FeRAM, assurant ainsi un fonctionnement résistif efficace de l'OxRAM, en dépit du dopage identique dans les couches actives pour l'OxRAM et la FeRAM.

En outre, le procédé selon l'invention permet de s'affranchir d'un recuit laser sub-microseconde localisé. En effet, la cristallisation adéquate du dioxyde d'hafnium dans la forme orthorhombique lui conférant des propriétés ferroélectriques est obtenue directement via le budget thermique des différentes étapes de fabrication, notamment en intégration « back end » compatible avec la technologie CMOS. Par ailleurs, le fait d'utiliser une couche active à base d'HfO₂ cristallisé dans sa phase orthorhombique ne nuit pas au fonctionnement de la mémoire OxRAM pour laquelle l'homme du métier utilise habituellement du HfO₂ amorphe ou monoclinique.

Outre les caractéristiques qui viennent d'être évoquées dans le paragraphe précédent, le procédé selon un aspect de l'invention peut présenter une ou plusieurs caractéristiques complémentaires parmi les suivantes, considérées individuellement ou selon toutes les combinaisons techniquement possibles :
- l'étape de réalisation du masque au niveau de la zone de la première couche conductrice destinée à former la mémoire ferroélectrique en laissant libre la zone de la première couche conductrice destinée à former la mémoire résistive OxRAM comporte les étapes suivantes :
   - Une étape de dépôt d'un masque sur la première couche conductrice au niveau de la zone de la première couche conductrice destinée à former la mémoire ferroélectrique et de la zone de la première couche conductrice destinée à former la mémoire résistive OxRAM ;
   - Une étape de retrait du masque au niveau de la zone de la première couche conductrice destinée à former la mémoire résistive OxRAM en laissant le masque au niveau de la zone de la première couche conductrice destinée à former la mémoire ferroélectrique.
- Le procédé selon l'invention comporte, à la suite de l'étape de dépôt de la couche de matériau actif à base de dioxyde d'hafnium, une étape de dopage de la couche de matériau actif réalisée de manière identique pour la zone destinée à former la mémoire résistive OxRAM et la zone destinée à former la mémoire ferroélectrique
- l'étape de dopage est réalisée par implantation ionique ou à l'aide d'un précurseur de dopage ou par co-sputtering.
- l'élément dopant utilisé pour l'étape de dopage est choisi parmi l'un des éléments suivants : Si, Al, Zr, Gd, Ge, Y ou N ;
- l'élément dopant est le Si (l'étape de dopage étant réalisée de préférence par implantation ionique et préférentiellement avec une épaisseur de couche de matériau actif de l'ordre de 10nm) et la couche de matériau actif est exposée à une dose de dopant comprise entre 10¹⁴ ions/cm² et 5.10¹⁴ ions/cm² ;
- le procédé selon l'invention comporte une étape de traitement thermique pour cristalliser la couche de matériau actif dans une phase orthorhombique.

La présente invention a également pour objet un dispositif comportant une mémoire résistive OxRAM agencée dans une première zone dédiée et une mémoire ferroélectrique agencée dans une deuxième zone dédiée,
la mémoire ferroélectrique comportant une première électrode, une deuxième électrode et une couche de matériau actif à bas de dioxyde d'hafnium disposée entre la première électrode et la deuxième électrode,
la mémoire résistive OxRAM comportant une première électrode, une deuxième électrode et une couche de matériau actif à base de dioxyde d'hafnium disposée entre la première électrode et la deuxième électrode,
les électrodes inférieures des mémoires ferroélectrique et résistive OxRAM étant formées par une même couche de première électrode présente sur les première et deuxième zones dédiées,
les couches de matériau actif à base de dioxyde d'hafnium HfO₂ des mémoires ferroélectrique et résistive OxRAM étant formées par une même couche de matériau actif à base de dioxyde d'hafnium présente sur les première et deuxième zones dédiées,
la deuxième électrode de la mémoire ferroélectrique étant formée par un tri-couche comportant dans la deuxième zone dédiée, une première couche conductrice en contact avec la couche active, une deuxième couche conductrice sur la première couche conductrice et une troisième couche conductrice sur la deuxième couche conductrice,
la deuxième électrode de la mémoire résistive OxRAM étant formée par un bicouche comportant dans la première zone dédiée, la deuxième couche conductrice en contact avec la couche active et la troisième couche conductrice sur la première couche conductrice,
le matériau de la seconde couche conductrice étant choisi pour créer des lacunes d'oxygène dans la couche active de la mémoire résistive OxRAM lorsque la seconde couche conductrice est en contact avec la couche active de la mémoire résistive OxRAM.

Le dispositif selon l'invention peut notamment être obtenu par le procédé de co-fabrication selon l'invention.

Outre les caractéristiques qui viennent d'être évoquées dans le paragraphe précédent, le dispositif selon l'invention peut présenter une ou plusieurs caractéristiques complémentaires parmi les suivantes, considérées individuellement ou selon toutes les combinaisons techniquement possibles :
- l'épaisseur de la couche active et/ou l'épaisseur de la deuxième couche conductrice est typiquement comprise entre 3nm et 15nm.
- l'épaisseur de la troisième couche conductrice est typiquement comprise entre 20nm et 200nm.
- la mémoire ferroélectrique comporte une cuvette présentant une paroi interne sur laquelle sont successivement agencée la couche de première électrode, la couches de matériau actif à base de dioxyde d'hafnium, le tri-couche comportant la première couche conductrice, la deuxième couche conductrice et la troisième couche conductrice sur la deuxième couche conductrice.

La présente invention a également pour objet un procédé d'entrainement et d'inférence d'un système d'intelligence artificielle comportant un dispositif selon l'invention, la mémoire ferroélectrique étant utilisée lors des phases d'entraînement et la mémoire résistive OxRAM étant utilisée lors des phases d'inférence.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- Les figures 1 à 10 illustrent les différentes étapes du procédé de co-fabrication d'une mémoire ferroélectrique et d'une mémoire OxRAM selon un premier mode de réalisation de l'invention.
- La figure 11 montre l'organigramme des étapes du procédé selon un premier mode de réalisation de l'invention illustrées aux figures 1 à 10.
- La figure 12 illustre une variante de réalisation du procédé de la figure 11
- Les figures 13 à 23 illustrent les différentes étapes du procédé de co-fabrication d'une mémoire ferroélectrique et d'une mémoire OxRAM selon un second mode de réalisation de l'invention.
- La figure 24 montre l'organigramme des étapes du procédé selon un second mode de réalisation de l'invention illustrées aux figures 13 à 23.
- La figure 25 illustre le fonctionnement des mémoires ferroélectriques
- La figure 26 illustre une mémoire ferroélectrique et une mémoire OxRAM selon l'invention cointégrées en backend sur transistor CMOS.

### DESCRIPTION DETAILLEE D'AU MOINS UN MODE DE REALISATION DE L'INVENTION

Sauf précision contraire, un même élément apparaissant sur des figures différentes présente une référence unique.

L'invention concerne un procédé de co-fabrication d'une mémoire ferroélectrique FeRAM et d'une mémoire OxRAM ayant chacune pour matériau actif du dioxyde d'hafnium HfO₂ ou un matériau à base de dioxyde d'hafnium, comme par exemple un aliage du type HfZrO₂ (dans le cas du HfZrO₂, les étapes de dépôt et de dopage de la couche active en HfO₂ peuvent être considérées comme équivalentes au dépôt de l'alliage ternaire HfZrO₂). Ce dernier présente des propriétés ferroélectriques quand il est dopé avec un élément dopant particulier de manière à obtenir une concentration en élément dopant adéquate, puis cristallisé en phase orthorhombique. Ce matériau est également utilisable dans des mémoires résistives de type OxRAM, basées sur la formation d'un filament conducteur lorsque le matériau présente des lacunes d'oxygène.

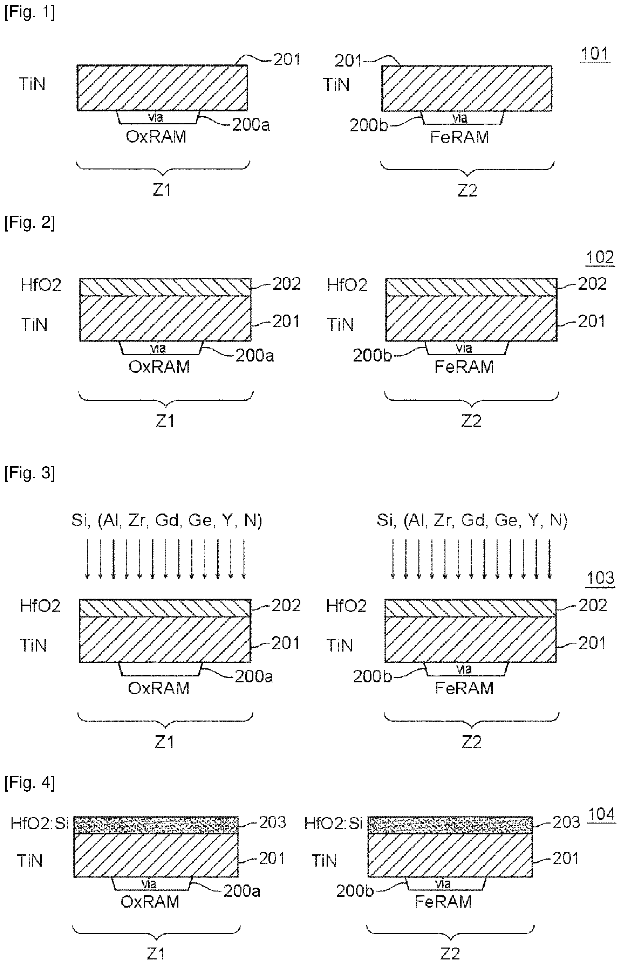

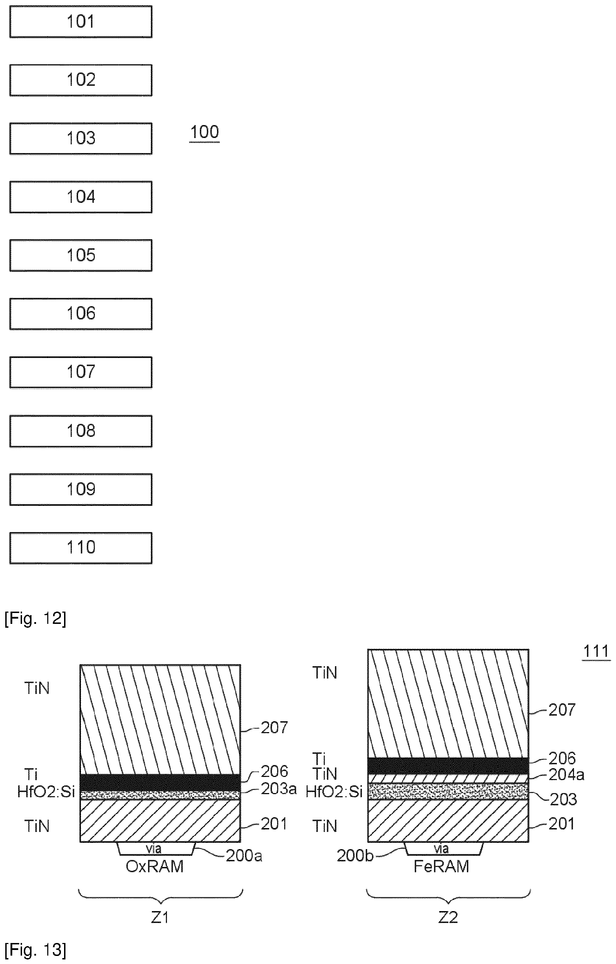

Les figures 1 à 10 illustrent les différentes étapes 101 à 110 (organigramme de la [Fig 11]) d'un premier mode de réalisation du procédé 100 de co-fabrication selon l'invention.
[Fig 1] illustre la première étape 101 du procédé 100 selon un aspect de l'invention.
[Fig 2] illustre la deuxième étape 102 du procédé 100 selon un aspect de l'invention.
[Fig 3] illustre la troisième étape 103 du procédé 100 selon un aspect de l'invention.
[Fig 4] illustre la quatrième étape 104 du procédé 100 selon un aspect de l'invention.

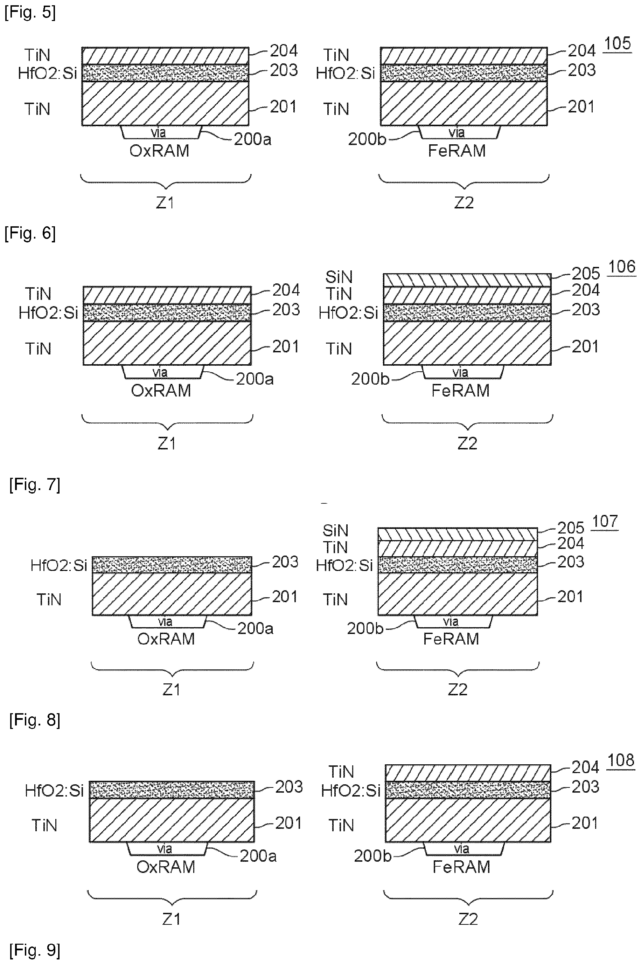

[Fig 5] illustre la cinquième étape 105 du procédé 100 selon un aspect de l'invention.
[Fig 6] illustre la sixième étape 106 du procédé 100 selon un aspect de l'invention.
[Fig 7] illustre la septième étape 107 du procédé 100 selon un aspect de l'invention.
[Fig 8] illustre la huitième étape 108 du procédé 100 selon un aspect de l'invention.

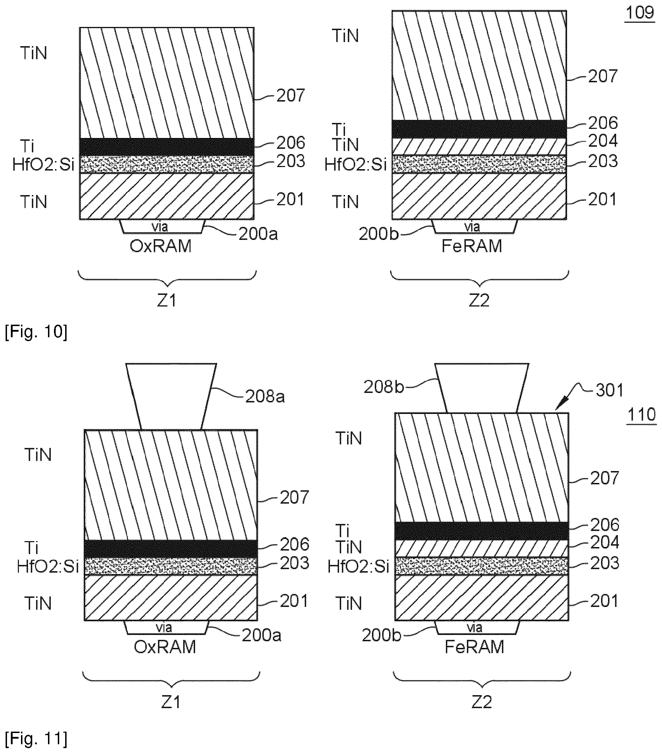

[Fig 9] illustre la neuvième étape 109 du procédé 100 selon un aspect de l'invention.
[Fig 10] illustre la dixième étape 110 du procédé 100 selon un aspect de l'invention.
[Fig 11] montre l'organigramme des étapes du procédé selon un aspect de l'invention illustrées aux figures 1 à 10.

Le procédé 100 selon l'invention comprend une étape 101 de dépôt conforme d'une couche de première électrode 201 représentée à la figure 1. Ce dépôt est réalisé de façon identique pour la zone Z1 destinée à former la mémoire résistive OxRAM et la zone Z2 destinée à former la mémoire ferroélectrique FeRAM. En d'autres termes, une unique couche de première électrode 201 est déposée : la partie de la couche de première électrode située dans la première zone Z1 est destinée à être la couche de première électrode 201 de la mémoire résistive OxRAM tandis que la partie de la couche de première électrode située dans la deuxième zone Z2 est destinée à être la couche de première électrode 201 de la mémoire ferroélectrique FeRAM. Par souci de clarté illustrative, la couche 201 a été représentée en deux parties sur les zones Z1 et Z2 mais il est entendu qu'il s'agit bien d'une couche unique qui est déposée pour former les deux mémoires OxRAM et FeRAM, une isolation pouvant être ensuite réalisée entre lesdites mémoires.

La couche de première électrode 201 est par exemple disposée sur des via 200a et 200b, par exemple en tungstène, respectivement destinés à connecter les mémoires OxRAM et FeRAM à des niveaux métalliques inférieurs en Cu. La première électrode 201 est désignée comme électrode inférieure (ou « bottom electrode » selon la terminologie anglaise) à la fois pour l'OxRAM et la FeRAM. Bien entendu, La couche de première électrode 201 peut également être déposée sur un substrat non représenté.

Le matériau conducteur de la couche de première électrode 201 est par exemple du nitrure de titane TiN. Le TiN est un exemple non limitatif mais d'autres matériaux conducteurs tels que le TaN ou le W pourraient également être utilisés.

Le dépôt est par exemple un dépôt physique en phase vapeur ou PVD pour « Physical Vapor Deposition ».

L'épaisseur de la couche de première électrode 201 est par exemple comprise entre 10 nm et 200 nm.

Le procédé 100 selon l'invention comporte ensuite une étape 102 de dépôt d'une couche de matériau actif 202 représentée à la figure 2 consistant à réaliser un dépôt conforme de dioxyde d'hafnium HfO₂. De même que pour l'étape 101 de dépôt la couche d'électrode 201, l'étape de dépôt de la couche de matériau actif 202 consiste à déposer une unique couche de matériau actif 202, la première zone Z1 de cette unique couche de matériau actif 202 étant destinée à être la couche de matériau actif 202 de la mémoire résistive OxRAM et la deuxième zone Z2 de la couche de matériau actif 202 étant destinée à être la couche de matériau actif 202 de la mémoire ferroélectrique FeRAM.

Le dépôt de la couche de matériau actif 202 peut être réalisé directement sur la couche de première électrode 201 ou sur une autre couche préalablement déposée sur la couche de première électrode 201.

Le dépôt est par exemple un dépôt de couches minces atomiques ou ALD pour « Atomic Layer Déposition » entre 200 et 300°C qui permet de déposer des couches de faibles épaisseurs, ici par exemple comprise entre 5 et 10 nm. Ce type d'épaisseur d'HfO₂ est compatible avec une épaisseur de couche active utilisable à la fois pour des fonctionnements en OxRAM et en FeRAM. L'épaisseur de la couche de matériau actif 202 est par exemple d'environ 10 nm.

Le procédé 100 comporte également une étape de dopage 103 de la couche de matériau actif 202. On entend par « dopage d'une couche », l'action d'introduire dans le matériau de la couche des atomes d'un autre matériau appelés impuretés.

Selon un mode de réalisation représenté sur la figure 3, l'étape 103 de dopage est réalisée par implantation ionique. Le dopage par implantation ionique consiste à accélérer des impuretés ionisées avec un champ électrique, afin de leur conférer l'énergie nécessaire pour rentrer dans le matériau à doper.

L'élément dopant utilisé est préférentiellement du silicium Si. Toutefois, d'autres éléments dopants tels que l'aluminium Al, le Zirconium Zr, le germanium Ge, le gadolinium Gd, l'Yttrium Y ou l'Azote N pourraient également être utilisés.

Selon cette étape 103, la totalité de la couche 202 (i.e. à la fois sur la zone Z1 dédiée à la réalisation de l'OxRAM et sur la zone Z2 dédiée à la réalisation de la FeRAM) est dopée de façon identique.

La couche de matériau actif 202 est par exemple exposée à une dose de dopant comprise entre 10¹⁴ ions/cm² et 5.10¹⁴ ions/cm² à une énergie comprise entre 2keV et 4keV. Cette gamme de dopage est compatible non seulement avec une utilisation de la couche active dans une mémoire résistive OxRAM (sous réserve de la création de lacunes d'oxygène sur laquelle nous reviendrons plus bas) mais aussi avec une utilisation de la couche active dans une mémoire FeRAM afin d'obtenir une phase orthorhombique avec un budget thermique adapté. Contrairement à la demande de brevet FR3090196 où la couche active de la zone Z1 était sur-dopée par rapport à la couche active de la zone Z2, la couche active 202 est donc ici dopée de façon identique.

Selon un mode de réalisation non représentée, l'étape 103 de dopage peut également être réalisée en même temps que le dépôt de la couche active à l'aide d'un précurseur de dopage. Par exemple, le précurseur de dopage est utilisé pendant le dépôt ALD en alternant les cycles de dépôt de dioxyde d'hafnium HfO₂ et d'éléments dopants et le nombre de cycles (i.e. on parle de super-cycles ALD). Le précurseur de dopage est par exemple du dioxyde de silicium SiO₂.

Selon un autre mode de réalisation non représenté, le dopage peut également être réalisé en même temps que la couche active par co-sputtering via un dépôt en phase vapeur PVD (« Phase Vapor Déposition ») ou via un dépôt par ablation laser à impulsions PLD (« Pulse Laser Déposition »).

A l'issue de l'étape 103 de dopage représentée à l'étape 104 de la figure 4, la couche de matériau actif 202 est devenue une couche 203 de matériau actif en HfO2 dopée, par exemple au Si.

Le procédé 100 selon l'invention comporte alors une étape 105 (figure 5) de dépôt d'une première couche conductrice 204 sur la couche de matériau actif HfO₂ dopée 203. Ce dépôt est réalisé de façon identique pour la zone Z1 destinée à former la mémoire résistive OxRAM et la zone Z2 destinée à former la mémoire ferroélectrique FeRAM.

Le matériau conducteur de la première couche conductrice 204 est par exemple du nitrure de titane TiN. Le TiN est un exemple non limitatif mais d'autres matériaux conducteurs tels que le TaN ou le W pourraient également être utilisés.

Le dépôt est par exemple un dépôt physique en phase vapeur ou PVD pour « Physical Vapor Deposition ».

L'épaisseur de la première couche conductrice 204 est de l'ordre de 10nm ou plus.

Le procédé selon l'invention comporte ensuite une étape 106 de réalisation d'un masque 205 au niveau de la zone Z2 de la première couche conductrice 204 destinée à former la mémoire ferroélectrique en laissant libre la zone Z1 de la première couche conductrice 204 destinée à former la mémoire résistive OxRAM. Le masque 205 est par exemple réalisé en nitrure de silicium SiN, en oxyde de silicium SiO₂ ou en résine. Le masque 205 recouvre donc la partie de la première couche conductrice 204 située dans la zone Z2. De façon connue, la réalisation du masque 205 peut se faire par exemple via :
- le dépôt conforme d'un masque dur recouvrant la première couche conductrice à la fois dans la zone Z1 et dans la zone Z2 ;
- le retrait de la partie du masque dur au niveau de la zone Z1 avec arrêt sur la première couche conductrice 204. L'étape de retrait est par exemple réalisée par lithographie et gravure.

Ainsi, à l'issue de l'étape 106, la zone Z1 de la première couche conductrice 204 est seule directement accessible en surface.

Le procédé 100 comporte une étape 107 de retrait de la première couche conductrice 204 au niveau de la zone Z1 de la première couche conductrice destinée à former la mémoire résistive OxRAM, la zone Z2 de la première couche conductrice 204 destinée à former la mémoire ferroélectrique étant protégée par le masque 205. Cette opération de retrait est réalisée par exemple par une gravure plasma de la première couche conductrice 204, par exemple en TiN, la gravure plasma du TiN étant très sélective par rapport au matériau HfO₂ de la couche active 203 de sorte que la gravure s'arrête sur la couche active 203 d'HfO₂ dans la zone Z1.

Le procédé 100 comporte ensuite une étape 108 de retrait du masque 205 au niveau de la zone Z2 destinée à former la mémoire ferroélectrique avec arrêt sur la première couche conductrice 204. A l'issue de cette étape 108, la couche active 203 est nue dans la zone Z1 et recouverte par la première couche conductrice 204 dans la zone Z2. L'opération de retrait du masque 205 est par exemple réalisée via un plasma Oxygène (« oxygen stripping » selon la terminologie anglaise) dans le cas où le masque 205 est en résine.

Le procédé 100 comporte alors une étape 109 de dépôt conforme d'une seconde couche conductrice 206, ladite seconde couche conductrice 206 étant en contact avec la première couche conductrice 204 au niveau de la zone Z2 destinée à former la mémoire ferroélectrique et en contact avec la couche 203 de matériau actif au niveau de la zone Z1 destinée à former la mémoire résistive OxRAM puis de dépôt conforme d'une troisième couche conductrice 207 réalisée de manière identique pour la zone Z1 destinée à former la mémoire résistive OxRAM et la zone Z2 destinée à former la mémoire ferroélectrique, ladite troisième couche conductrice 207 étant en contact avec la seconde couche conductrice 206.

Le dépôt des couches 206 et 207 est par exemple un dépôt physique en phase vapeur ou PVD pour « Physical Vapor Deposition ».

Le matériau conducteur de la troisième couche conductrice 207 est par exemple du nitrure de titane TiN. Le TiN est un exemple non limitatif mais d'autres matériaux conducteurs, tels que le TaN, pourraient également être utilisés. On notera que le matériau choisi pour la troisième couche conductrice 207 peut être différent du matériau choisi pour la première couche conductrice 204.

L'épaisseur de la troisième couche conductrice 207 est par exemple comprise entre 20 nm et 200 nm.

Le matériau conducteur de la deuxième couche conductrice 206 est choisi pour être un matériau adapté pour pomper l'oxygène (« oxygen scavening layer » selon la terminologie anglaise) présent dans la couche active 203 située dans la zone Z1 sur laquelle la deuxième couche conductrice 206 est déposée. En pompant l'oxygène dans la couche active 206, la deuxième couche conductrice 206 va créer des lacunes d'oxygène dans la partie de la couche active 203 dédiée à la réalisation de l'OxRAM, les lacunes d'oxygène étant nécessaires au bon fonctionnement de l'OxRAM. La deuxième couche conductrice 206 étant en revanche déposée sur la première couche conductrice 204 dans la zone Z2 dédiée à la FeRAM, elle n'est donc pas en contact avec la couche active 203 dans la zone Z2 et ne créera donc pas de lacune dans la couche active 203 côté Z2. Le matériau de la deuxième couche conductrice 206 est par exemple du titane Ti ou de l'Hafnium lorsque le matériau de la troisième couche conductrice 207 est du TiN. Il peut également s'agir de Tantale Ta l'Hafnium lorsque le matériau de la troisième couche conductrice 207 est du TaN. On notera que le Ti (respectivement le Ta) est un bon matériau d'accroche pour la couche supérieure en TiN (respectivement en TaN).

L'épaisseur de la deuxième couche conductrice 206 est sensiblement identique à l'épaisseur de la couche active 203, par exemple comprise entre 5 nm et 10 nm.

Selon l'étape 110 du procédé 100 illustrée en figure 10, on réalise deux via supérieurs 208a et 208b sur la troisième couche conductrice 207, respectivement au niveau de la zone Z1 dédiée à l'OxRAM et au niveau de la zone Z2 dédiée à la FeRAM.

[Fig 12] illustre une variante 111 du procédé 100 selon un aspect de l'invention. Ainsi entre l'étape 108 et l'étape 109, il est possible de retirer une partie (référencée ici 203a) de l'épaisseur de la couche active au niveau de la zone Z1 dédiée à l'OxRAM et une partie (référencée ici 204a) de l'épaisseur de la première couche conductrice au niveau de la zone Z2 dédiée à la FeRAM. Cette étape 111 se situe avant le dépôt des deuxième et troisième couches conductrices. Ce retrait peut être par exemple réalisé par plasma argon qui permet de rétirer de manière uniforme et contrôlée quelques nanomètres des couches supérieures, indépendamment de leur nature chimique (plasma type "preclean"). Il permet à la fois d'enlever l'oxyde natif sur la première couche conductrice (par exemple en TiN) et diminuer l'épaisseur du matériau actif du côté de l'OxRAM (permettant ainsi notamment de réduire les tensions de forming et d'écriture de l'OxRAM).

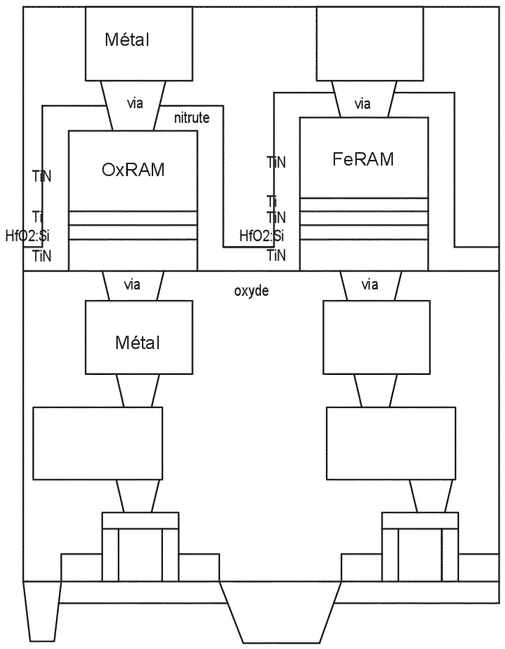

Il faut que le matériau de la couche active 203 soit cristallisé dans une phase orthorhombique pour permettre le fonctionnement de cette dernière en mémoire ferroélectrique dans la zone Z2. Pour ce faire, plusieurs solutions sont envisageables. La première peut consister à faire un recuit à une température adaptée au process backend, comprise entre 300°C et 500°C, par exemple de l'ordre de 450°C : ce recuit peut par exemple intervenir à l'étape 105 (avant ou, de préférence, après le dépôt de la première couche conductrice 204). On peut cependant s'affranchir de ce recuit en utilisant le budget thermique cumulé de l'ordre de 300°C du procédé de fabrication de la figure 11 auquel on ajoute la fin du procédé de fabrication non représenté ici et incluant notamment l'encapsulation des points mémoires OxRAM et FeRAM par des espaceurs ou par une couche continue d'isolant après intégration backend des points mémoires au-dessus des transistors CMOS. De façon générale, on réalise donc un traitement thermique de la couche active 203 de façon à la cristalliser dans sa phase orthorhombique, ce traitement thermique pouvant être soit un recuit (réalisé de façon préférentielle après le dépôt de la première couche conductrice 204) soit un traitement thermique assurant la cristallisation orthorhombique sans nécessairement de recuit spécifique, via la réalisation des étapes conduisant à l'encapsulation des mémoires OxRAM et FeRAM. Un exemple d'encapsulation des niveaux transistors CMOS et des niveaux mémoires OxRAM et FeRAM intégrés en backend et encapsulés dans une couche d'oxyde est illustré à la [Fig 26].

À l'issue du procédé 100 selon l'invention, on obtient donc un dispositif co-intégrant une mémoire ferroélectrique agencée dans la zone dédiée Z2 et une mémoire OxRAM agencée dans la zone dédiée Z1. La mémoire ferroélectrique comporte une première électrode (dite électrode inférieure), une deuxième électrode (dite électrode supérieure) et une couche de matériau actif en dioxyde d'hafnium HfO₂ disposée entre la première électrode et la deuxième électrode. De même, la mémoire résistive OxRAM comporte une première électrode (dite électrode inférieure), une deuxième électrode (dite électrode supérieure) et une couche de matériau actif en dioxyde d'hafnium HfO₂ disposée entre la première électrode et la deuxième électrode. Les électrodes inférieures des mémoires FeRAM et OxRAM sont formées par la même couche de première électrode 201. Les couches de matériau actif en dioxyde d'hafnium HfO₂ des mémoires FeRAM et OxRAM sont formées par la même couche de matériau actif HfO₂ dopée 203 et cristallisé dans sa phase orthorhombique.

L'électrode supérieure de la FeRAM est formée par un tri-couche comportant dans sa zone dédiée Z2, la première couche conductrice 204, la deuxième couche conductrice 206 et la troisième couche conductrice 207.

L'électrode supérieure de l'OxRAM est formée par une bicouche comportant dans sa zone dédiée Z1, la deuxième couche conductrice 206 et la troisième couche conductrice 207.

Lorsque le dispositif selon l'invention se trouve dans son état originel, juste après sa fabrication, la zone de commutation (i.e. La couche active) de la mémoire OxRAM doit être formée pour la première fois en appliquant entre les deux électrodes de la mémoire OxRAM une tension de « forming » Vforming supérieure à sa tension d'écriture Vset. Ensuite, la mémoire résistive OxRAM entre dans un mode de fonctionnement normal dans lequel la tension d'écriture Vset et la tension d'effacement Vreset (de signe opposé à la tension d'écriture) sont utilisées pour faire basculer l'état de résistance de la mémoire résistive OxRAM.

En appliquant une tension de programmation en Pup aux bornes des électrodes de la mémoire FeRAM supérieure à la tension créant un champ électrique d'une valeur supérieure au champ coercitif positif +Ec, la mémoire ferroélectrique sera placée dans un état de polarisation rémanente haute +Pr. De même, en appliquant une tension en Pdown supérieure à la tension créant un champ électrique d'une valeur supérieure au champ coercitif négatif -Ec aux bornes de la mémoire FeRAM, cette dernière sera placée dans un état de polarisation rémanente basse -Pr.

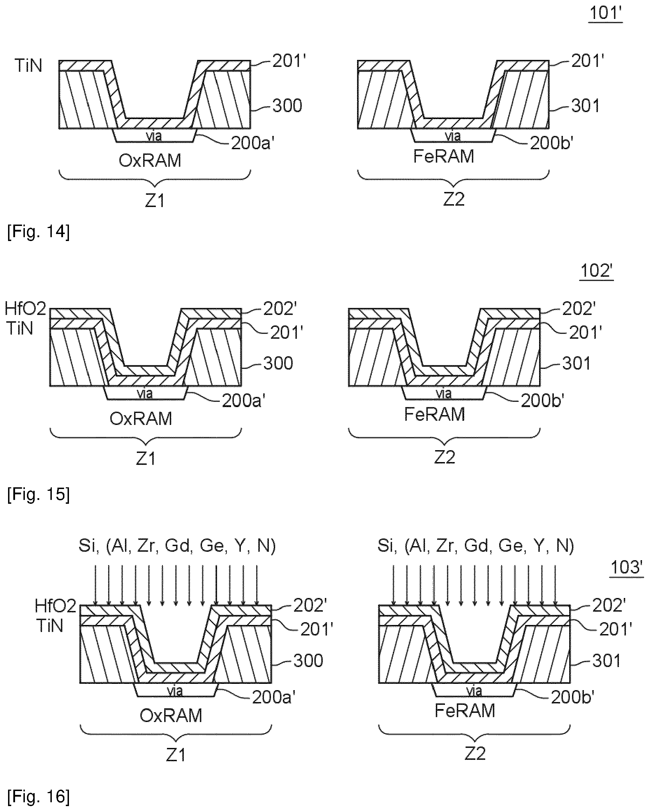

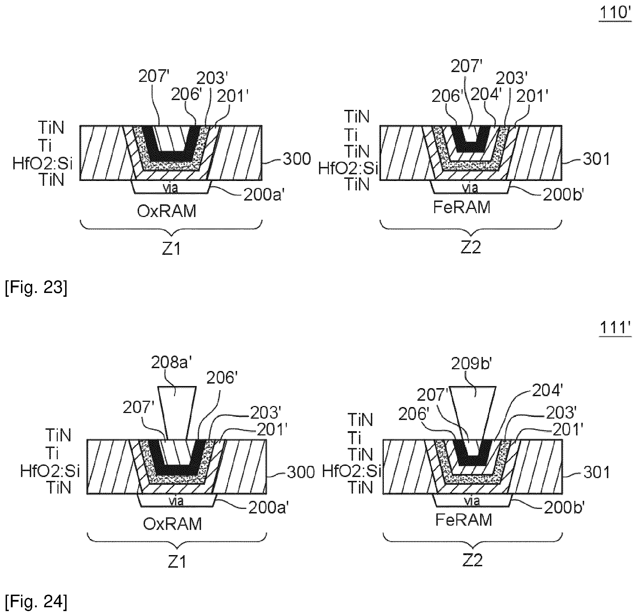

Les figures 13 à 23 illustrent les différentes étapes 101' à 111' (organigramme de la figure 23) d'un second mode de réalisation du procédé 100' de co-fabrication selon l'invention.

[Fig 13] illustre la première étape 101' du procédé 100' selon un aspect de l'invention.

[Fig 14] illustre la deuxième étape 102' du procédé 100' selon un aspect de l'invention.

[Fig 15] illustre la troisième étape 103' du procédé 100' selon un aspect de l'invention.

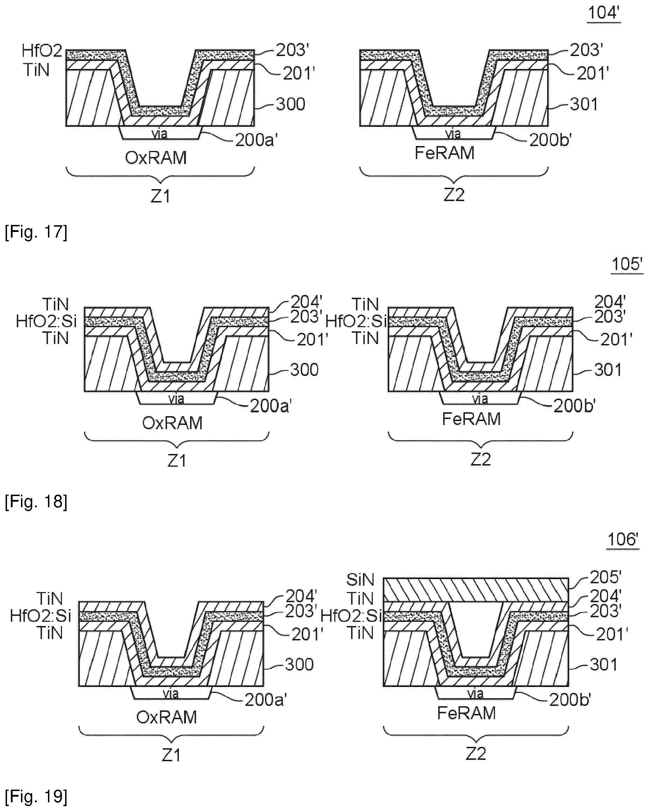

[Fig 16] illustre la quatrième étape 104' du procédé 100' selon un aspect de l'invention.

[Fig 17] illustre la cinquième étape 105' du procédé 100' selon un aspect de l'invention.

[Fig 18] illustre la sixième étape 106' du procédé 100' selon un aspect de l'invention.

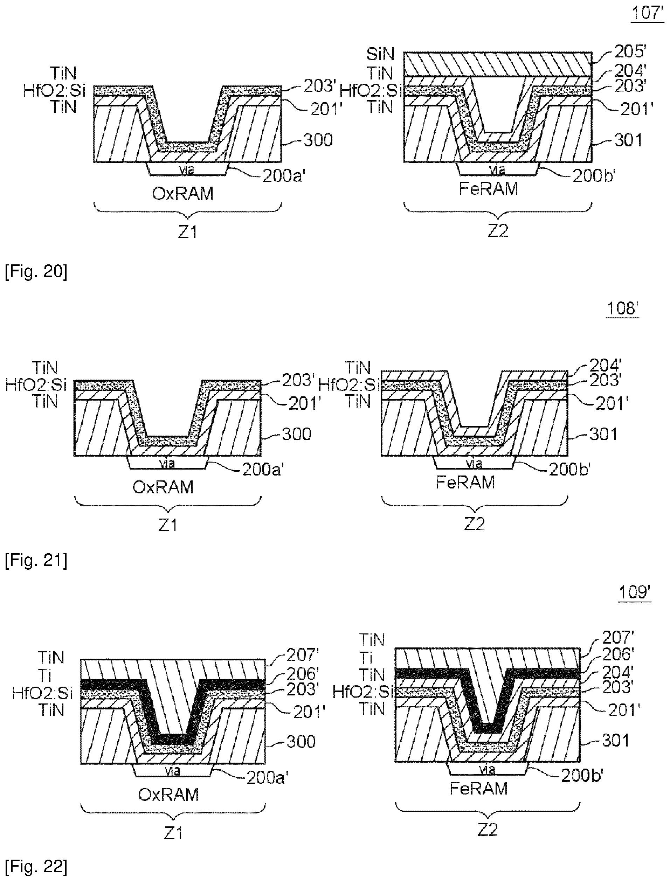

[Fig 19] illustre la septième étape 107' du procédé 100' selon un aspect de l'invention.

[Fig 20] illustre la huitième étape 108' du procédé 100' selon un aspect de l'invention.

[Fig 21] illustre la neuvième étape 109' du procédé 100' selon un aspect de l'invention.

[Fig 22] illustre la dixième étape 110' du procédé 100' selon un aspect de l'invention.

[Fig 23] illustre la onzième étape 111' du procédé 100' selon un aspect de l'invention.

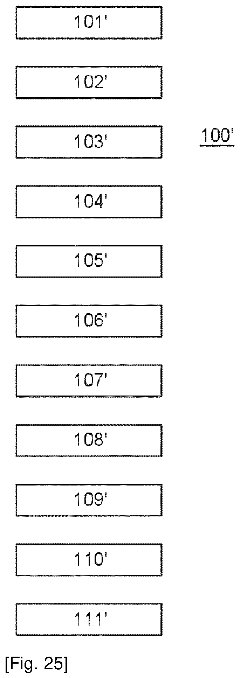

[Fig 24] montre l'organigramme des étapes du procédé 100' selon un aspect de l'invention illustrées aux figures 13 à 23.

Le procédé 100' selon le second mode de réalisation de l'invention est très proche du procédé 100 illustré précédemment à la différence qu'il vise à obtenir une architecture en trois dimensions pour les mémoires OxRAM et ferroélectrique cointégrées. L'intérêt d'une telle configuration est de pouvoir notamment augmenter, dans le cas de noeuds très avancés, la surface de la capacité de la FeRAM.

Le procédé 100' selon l'invention comprend une étape 101' de dépôt conforme d'une couche de première électrode 201' représentée à la figure 13. Ce dépôt est réalisé de façon identique pour la zone Z1 destinée à former la mémoire résistive OxRAM et la zone Z2 destinée à former la mémoire ferroélectrique FeRAM. En d'autres termes, une unique couche de première électrode 201' est déposée : la partie de la couche de première électrode 201' située dans la première zone Z1 est destinée à être la couche de première électrode 201' de la mémoire résistive OxRAM tandis que la partie de la couche de première électrode située dans la deuxième zone Z2 est destinée à être la couche de première électrode 201' de la mémoire ferroélectrique FeRAM. Par souci de clarté illustrative, la couche 201' a été représentée en deux parties sur les zones Z1 et Z2 mais il est entendu qu'il s'agit bien d'une couche unique qui est déposée pour former les deux mémoires OxRAM et FeRAM, une isolation pouvant être ensuite réalisée entre lesdites mémoires.

Contrairement au premier mode de réalisation, la couche de première électrode 201' est par exemple déposée dans une cuvette 300 dans la zone Z1 et une cuvette 301 dans la zone Z2, les deux cuvettes 300 et 301 étant par exemple disposées au-dessus de via 200a' et 200b', par exemple en tungstène, respectivement destinés à connecter les mémoires OxRAM et FeRAM à des niveaux métalliques inférieurs en Cu. La première électrode 201' est désignée comme électrode inférieure (ou « bottom electrode » selon la terminologie anglaise) à la fois pour l'OxRAM et la FeRAM. Les cuvettes 300 et 301 pourraient être remplacées par des via conducteurs dans lesquels la couche de première électrode 201' serait déposée. Les cuvettes 300 et 301 sont par exemple réalisées en un oxyde de type TEOS. Après dépôt du TEOS, ou d'un bicouche oxyde / SiN, on réalise par exemple un lithographie puis une gravure permettant de graver en formant les cuvettes jusqu'aux vias 200a' et 200b', puis on vient retirer la résine à l'aide d'un plasma oxygène.

Le matériau conducteur de la couche de première électrode 201' est par exemple du nitrure de titane TiN.

Le dépôt de la couche de première électrode 201' est par exemple un dépôt de couches atomiques ou ALD pour « Atomic Layer Déposition » le plus conforme possible pour que la couche 201' épouse la forme de la paroi intérieure respective des cuvettes 300 et 301.

L'épaisseur de la couche de première électrode 201' est par exemple comprise entre 10 nm et 200 nm.

Le procédé 100' selon l'invention comporte ensuite une étape 102' de dépôt d'une couche de matériau actif 202' représentée à la figure 14 consistant à réaliser un dépôt conforme de dioxyde d'hafnium HfO₂. De même que pour l'étape 101' de dépôt la couche d'électrode 201', l'étape de dépôt de la couche de matériau actif 202' consiste à déposer une unique couche de matériau actif 202', la première zone Z1 de cette unique couche de matériau actif 202' étant destinée à être la couche de matériau actif 202' de la mémoire résistive OxRAM et la deuxième zone Z2 de la couche de matériau actif 202' étant destinée à être la couche de matériau actif 202' de la mémoire ferroélectrique FeRAM.

Le dépôt est par exemple un dépôt très conforme de couches minces atomiques ou ALD pour « Atomic Layer Déposition » entre 200 et 300°C qui permet de déposer des couches de faibles épaisseurs, ici par exemple comprise entre 5 et 10 nm. Ce type d'épaisseur d'HfO₂ est compatible avec une épaisseur de couche active utilisable à la fois pour des fonctionnements en OxRAM et en FeRAM. L'épaisseur de la couche de matériau actif 202' est par exemple d'environ 10 nm. On comprend que l'utilisation de cuvettes donne une forme en trois dimensions aux mémoires permettant d'augmenter la surface de matériau actif, et donc la surface capacitive utile de la mémoire ferroélectrique.

Le procédé 100' comporte également une étape 103' de dopage de la couche de matériau actif 202'.

Selon un mode de réalisation représenté sur la figure 15, l'étape 103' de dopage est réalisée par implantation ionique par immersion plasma, de façon à avoir un dopage le plus conforme possible.

L'élément dopant utilisé est préférentiellement du silicium Si. Toutefois, d'autres éléments dopants tels que l'aluminium Al, le Zirconium Zr, le germanium Ge, le gadolinium Gd, l'Yttrium Y ou l'Azote N pourraient également être utilisés.

Selon cette étape 103', la totalité de la couche 202' (i.e. à la fois sur la zone Z1 dédiée à la réalisation de l'OxRAM et sur la zone Z2 dédiée à la réalisation de la FeRAM) est dopée de façon identique. La couche de matériau actif 202' est par exemple exposée à une dose de dopant comprise entre 10¹⁴ ions/cm² et 5.10¹⁴ ions/cm² à une énergie comprise entre 2keV et 4keV, dans le cas du dopage Si.

Comme pour le premier mode de réalisation, l'étape 103' de dopage peut également être réalisée en même temps que le dépôt de la couche active à l'aide d'un précurseur de dopage. Par exemple, le précurseur de dopage est utilisé pendant le dépôt ALD en alternant les cycles de dépôt de dioxyde d'hafnium HfO₂ et d'éléments dopants et le nombre de cycles (i.e. on parle de super-cycles ALD). Le précurseur de dopage est par exemple du dioxyde de silicium SiO₂. Le dopage peut également être réalisé en même temps que la couche active par co-sputtering via un dépôt en phase vapeur PVD (« Phase Vapor Déposition ») ou via un dépôt par ablation laser à impulsions PLD (« Pulse Laser Déposition »).

A l'issue de l'étape 103' de dopage représentée à l'étape 104' de la figure 16, la couche de matériau actif 202' est devenue une couche 203' de matériau actif en HfO2 dopée, par exemple au Si.

Le procédé 100' selon l'invention comporte alors une étape 105' (figure 17) de dépôt conforme d'une première couche conductrice 204' sur la couche de matériau actif HfO₂ dopée 203'. Ce dépôt est réalisé de façon identique pour la zone Z1 destinée à former la mémoire résistive OxRAM et la zone Z2 destinée à former la mémoire ferroélectrique FeRAM.

Le matériau conducteur de la première couche conductrice 204 est par exemple du nitrure de titane TiN. Le TiN est un exemple non limitatif mais d'autres matériaux conducteurs tels que le TaN ou le W pourraient également être utilisés.

Le dépôt est par exemple un dépôt physique en phase vapeur ou PVD pour « Physical Vapor Déposition » ou un dépôt de couches minces atomiques ou ALD pour « Atomic Layer Déposition ».

L'épaisseur de la première couche conductrice 204' est de l'ordre de 10nm ou plus.

Le procédé 100' selon l'invention comporte ensuite une étape 106' de réalisation d'un masque 205' au niveau de la zone Z2 de la première couche conductrice 204' destinée à former la mémoire ferroélectrique en laissant libre la zone Z1 de la première couche conductrice 204' destinée à former la mémoire résistive OxRAM. Le masque 205' est par exemple réalisé en nitrure de silicium SiN, en oxyde de silicium SiO₂ ou en résine. Le masque 205' recouvre donc la partie de la première couche conductrice 204' située dans la zone Z2. De façon connue, la réalisation du masque 205' peut se faire par exemple via :
- le dépôt d'un masque dur recouvrant la première couche conductrice à la fois dans la zone Z1 et dans la zone Z2 ;
- le retrait de la partie du masque dur au niveau de la zone Z1 avec arrêt sur la première couche conductrice 204'. L'étape de retrait est par exemple réalisée par lithographie et gravure.
Pas souci d'illustration, le masque 205' est représenté suspendu au-dessus de la cuvette 301 mais on ne cherche pas forcément à voir un masque dur suspendu au-dessus de la cuvette. Si le masque est en résine (déposé par spin-off), la résine remplira la cuvette, ce qui ne modifie pas le procédé décrit.

Ainsi, à l'issue de l'étape 106', la zone Z1 de la première couche conductrice 204' est seule directement accessible en surface.

Le procédé 100' comporte une étape 107' de retrait de la première couche conductrice 204' au niveau de la zone Z1 de la première couche conductrice destinée à former la mémoire résistive OxRAM, la zone Z2 de la première couche conductrice 204' destinée à former la mémoire ferroélectrique étant protégée par le masque 205'. Cette opération de retrait est réalisée par exemple par une gravure plasma de la première couche conductrice 204', par exemple en TiN, la gravure plasma du TiN étant très sélective par rapport au matériau HfO₂ de la couche active 203' de sorte que la gravure s'arrête sur la couche active 203' d'HfO₂ dans la zone Z1.

Le procédé 100' comporte ensuite une étape 108' de retrait du masque 205' au niveau de la zone Z2 destinée à former la mémoire ferroélectrique avec arrêt sur la première couche conductrice 204'. A l'issue de cette étape 108', la couche active 203' est nue dans la zone Z1 et recouverte par la première couche conductrice 204' dans la zone Z2. L'opération de retrait du masque 205' est par exemple réalisée via un plasma Oxygène (« oxygen stripping » selon la terminologie anglaise).

Le procédé 100' comporte alors une étape 109' de dépôt conforme d'une seconde couche conductrice 206', ladite seconde couche conductrice 206' étant en contact avec la première couche conductrice 204' au niveau de la zone Z2 destinée à former la mémoire ferroélectrique et en contact avec la couche 203' de matériau actif au niveau de la zone Z1 destinée à former la mémoire résistive OxRAM. L'étape 109' inclut également un dépôt non conforme d'une troisième couche conductrice 207' réalisée de manière identique pour la zone Z1 destinée à former la mémoire résistive OxRAM et la zone Z2 destinée à former la mémoire ferroélectrique, ladite troisième couche conductrice 207' étant en contact avec la seconde couche conductrice 206. Le dépôt de la troisième couche conductrice 207' est non conforme de façon à remplir les parties respectives des cuvettes 300 et 301 non encore remplies.

Le dépôt des couches 206' et 207' est par exemple un dépôt physique en phase vapeur ou PVD pour « Physical Vapor Déposition ». Le dépôt sera conforme ou non, le choix de la conformité pourra notamment dépendre du diamètre de la cuvette. Si le diamètre de la cuvette est typiquement inférieur 100nm, on privilégiera plutôt un dépôt conforme.

Le matériau conducteur de la troisième couche conductrice 207' est par exemple du nitrure de titane TiN. Le TiN est un exemple non limitatif mais d'autres matériaux conducteurs tels que le TaN pourraient également être utilisés. On notera que le matériau choisi pour la troisième couche conductrice 207' peut être différent du matériau choisi pour la première couche conductrice 204'.

L'épaisseur de la troisième couche conductrice 207' doit être telle que les cuvettes 300 et 301' soient totalement remplies.

Le matériau conducteur de la deuxième couche conductrice 206' est choisi pour être un matériau adapté pour pomper l'oxygène (« oxygen scavening layer » selon la terminologie anglaise) présent dans la couche active 203' située dans la zone Z1 sur laquelle la deuxième couche conductrice 206' est déposée. En pompant l'oxygène dans la couche active 206', la deuxième couche conductrice 206' va créer des lacunes d'oxygène dans la partie de la couche active 203' dédiée à la réalisation de l'OxRAM, les lacunes d'oxygène étant nécessaires au bon fonctionnement de l'OxRAM. La deuxième couche conductrice 206' étant en revanche déposée sur la première couche conductrice 204' dans la zone Z2 dédiée à la FeRAM, elle n'est donc pas en contact avec la couche active 203' dans la zone Z2 et ne créera donc pas de lacune dans la couche active 203' côté Z2. Le matériau de la deuxième couche conductrice 206' est par exemple du titane Ti ou de l'Hafnium lorsque le matériau de la troisième couche conductrice 207' est du TiN. Il peut également s'agir de Tantale Ta l'Hafnium lorsque le matériau de la troisième couche conductrice 207' est du TaN. On notera que le Ti (respectivement le Ta) est un bon matériau d'accroche pour la couche supérieure en TiN (respectivement en TaN).

L'épaisseur de la deuxième couche conductrice 206' est sensiblement identique à l'épaisseur de la couche active 203', par exemple comprise entre 5 nm et 10 nm.

Selon l'étape 110' du procédé 100' illustrée en figure 22, on réalise un retrait par polissage mécano-chimique contrôlé (CMP ou « Chemical mechanical polishing ») de l'ensemble des couches 207', 206',203', 201' avec arrêt sur la surface supérieure des cuvettes 300 et 301.

Selon l'étape 111 du procédé 100 illustrée en figure 10, on réalise deux vias supérieurs 208a' et 208b' sur la troisième couche conductrice 207', respectivement au niveau de la zone Z1 dédiée à l'OxRAM et au niveau de la zone Z2 dédiée à la FeRAM.

A l'issue du procédé 100' selon l'invention, on obtient donc un dispositif co-intégrant une mémoire ferroélectrique agencée dans la zone dédiée Z2 et une mémoire OxRAM agencée dans la zone dédiée Z1. La mémoire ferroélectrique est agencée en trois dimensions au sein d'une cuvette 301 dans laquelle la paroi intérieure est successivement recouverte d'une première électrode (dite électrode inférieure), d'une couche de matériau actif en dioxyde d'hafnium HfO₂ et d'une deuxième électrode (dite électrode supérieure). De même, la mémoire résistive OxRAM est agencée en trois dimensions au sein d'une cuvette 300 dans laquelle la paroi intérieure est successivement recouverte d'une première électrode (dite électrode inférieure), d'une couche de matériau actif en dioxyde d'hafnium HfO₂ et d'une deuxième électrode (dite électrode supérieure). Les électrodes inférieures des mémoires FeRAM et OxRAM sont formées par la même couche de première électrode 201'. Les couches de matériau actif en dioxyde d'hafnium HfO₂ des mémoires FeRAM et OxRAM sont formées par la même couche de matériau actif HfO₂ dopée 203' et cristallisé dans sa phase orthorhombique.

L'électrode supérieure de la FeRAM est formée par un tri-couche comportant successivement dans la cuvette 301, la première couche conductrice 204', la deuxième couche conductrice 206' et la troisième couche conductrice 207'.

L'électrode supérieure de l'OxRAM est formée par une bicouche comportant successivement dans la cuvette 300, la deuxième couche conductrice 206' et la troisième couche conductrice 207'.

Selon une variante du procédé 100' selon le deuxième mode de réalisation de l'invention, entre l'étape 108' et l'étape 109', il est possible de retirer une partie de l'épaisseur de la couche active au niveau de la zone Z1 dédiée à l'OxRAM et une partie de l'épaisseur de la première couche conductrice au niveau de la zone Z2 dédiée à la FeRAM. Cette étape se situe avant le dépôt des deuxième et troisième couches conductrices.

Comme précédemment dans le cas du procédé 100 selon un premier mode de réalisation, il convient que le matériau de la couche active 203' soit cristallisée dans une phase orthorhombique pour permettre le fonctionnement de cette dernière en mémoire ferroélectrique dans la zone Z2.

Le fonctionnement en forming, écriture et lecture des mémoires est identique à celui précédemment décrit.

Selon un troisième mode de réalisation du procédé selon l'invention, il est possible de réaliser une mémoire résistive OxRAM en deux dimensions telle que décrite en référence au procédé 100 selon le premier mode de réalisation et une mémoire ferroélectrique en trois dimensions (i.e. dans une cuvette afin d'augmenter la surface capacitive) telle que décrite en référence au procédé 100' selon le second mode de réalisation de l'invention.

## Revendications

1. Procédé (100, 100') de co-fabrication d'une mémoire ferroélectrique comportant une première électrode, une deuxième électrode et une couche de matériau actif à base de dioxyde d'hafnium disposée entre la première électrode et la deuxième électrode et d'une mémoire résistive OxRAM comportant une première électrode, une deuxième électrode et une couche de matériau actif à base de dioxyde d'hafnium disposée entre la première électrode et la deuxième électrode, le procédé de co-fabrication comportant les étapes suivantes :
- Une étape de dépôt (101, 101') d'une couche de première électrode (201, 201') réalisée de manière identique pour la zone (Z1) destinée à former la mémoire résistive OxRAM et la zone (Z2) destinée à former la mémoire ferroélectrique ;
- Une étape de dépôt (102, 102') d'une couche de matériau actif à base de dioxyde d'hafnium (202, 202') réalisée de manière identique pour la zone (Z1) destinée à former la mémoire résistive OxRAM et la zone (Z2) destinée à former la mémoire ferroélectrique ;
- Une étape de dépôt (105, 105') d'une première couche conductrice (204, 204') réalisée de manière identique pour la zone (Z1) destinée à former la mémoire résistive OxRAM et la zone (Z2) destinée à former la mémoire ferroélectrique ;
- Une étape de réalisation (106, 106') d'un masque (205, 205') au niveau de la zone (Z2) de la première couche conductrice destinée à former la mémoire ferroélectrique en laissant libre la zone (Z1) de la première couche conductrice destinée à former la mémoire résistive OxRAM ;
- Une étape de retrait (107, 107') de la première couche conductrice (204, 204') au niveau de la zone (Z1) de la première couche conductrice destinée à former la mémoire résistive OxRAM, la zone (Z2) de la première couche conductrice destinée à former la mémoire ferroélectrique étant protégée par le masque (205, 205') ;
- Une étape de retrait (108, 108') du masque (205, 205') au niveau de la zone (Z2) de la première couche conductrice destinée à former la mémoire ferroélectrique ;
- Une étape de dépôt (109, 109') d'une seconde couche conductrice (206, 206'), ladite seconde couche conductrice (206, 206') étant en contact avec la première couche conductrice (204, 204') au niveau de la zone (Z2) de la première couche conductrice destinée à former la mémoire ferroélectrique et en contact avec la couche de matériau actif (203, 203') au niveau de la zone (Z1) de la première couche conductrice destinée à former la mémoire résistive OxRAM, le matériau de la seconde couche conductrice (206, 206') étant choisi pour créer des lacunes d'oxygène dans la couche active de la mémoire résistive OxRAM lorsque la seconde couche conductrice est en contact avec la couche active (203, 203') de la mémoire résistive OxRAM ;
- Une étape de dépôt (109, 109') d'une troisième couche conductrice (207, 207') réalisée de manière identique pour la zone (Z1) destinée à former la mémoire résistive OxRAM et la zone (Z2) destinée à former la mémoire ferroélectrique, ladite troisième couche conductrice (207, 207') étant en contact avec la seconde couche conductrice (206, 206').

2. Procédé selon la revendication 1 **caractérisé en ce que** l'étape de réalisation du masque au niveau de la zone de la première couche conductrice destinée à former la mémoire ferroélectrique en laissant libre la zone de la première couche conductrice destinée à former la mémoire résistive OxRAM comporte les étapes suivantes :
- Une étape de dépôt d'un masque sur la première couche conductrice au niveau de la zone de la première couche conductrice destinée à former la mémoire ferroélectrique et de la zone de la première couche conductrice destinée à former la mémoire résistive OxRAM;
- Une étape de retrait du masque au niveau de la zone de la première couche conductrice destinée à former la mémoire résistive OxRAM en laissant le masque au niveau de la zone de la première couche conductrice destinée à former la mémoire ferroélectrique.

3. Procédé selon l'une des revendications précédentes **caractérisé en ce qu'**il comporte, à la suite de l'étape de dépôt (102, 102') de la couche de matériau actif à base de dioxyde d'hafnium (202, 202'), une étape de dopage (103, 103') de la couche de matériau actif (202, 202') réalisée de manière identique pour la zone (Z1) destinée à former la mémoire résistive OxRAM et la zone (Z2) destinée à former la mémoire ferroélectrique.

4. Procédé selon la revendication précédente **caractérisé en ce que** l'étape de dopage est réalisée par implantation ionique ou à l'aide d'un précurseur de dopage ou par co-sputtering.

5. Procédé selon l'une des revendications 3 ou 4 **caractérisé en ce que** l'élément dopant utilisé pour l'étape de dopage est choisi parmi l'un des éléments suivants : Si, Al, Zr, Gd, Ge, Y ou N.

6. Procédé selon l'une des revendications 3 à 5 **caractérisé en ce que** l'élément dopant est du Si et, durant l'étape de dopage, la couche de matériau actif est exposée à une dose de dopant comprise entre 10¹⁴ ions/cm² et 5.10¹⁴ ions/cm².

7. Dispositif comportant une mémoire résistive OxRAM agencée dans une première zone dédiée et une mémoire ferroélectrique agencée dans une deuxième zone dédiée,
- la mémoire ferroélectrique comportant une première électrode, une deuxième électrode et une couche de matériau actif à base de dioxyde d'hafnium disposée entre la première électrode et la deuxième électrode,
- la mémoire résistive OxRAM comportant une première électrode, une deuxième électrode et une couche de matériau actif à base de dioxyde d'hafnium disposée entre la première électrode et la deuxième électrode,
- les électrodes inférieures des mémoires ferroélectrique et résistive OxRAM étant formées par une même couche de première électrode présente sur les première et deuxième zones dédiées,
- les couches de matériau actif à base de dioxyde d'hafnium des mémoires ferroélectrique et résistive OxRAM étant formées par une même couche de matériau actif à base de dioxyde d'hafnium présente sur les première et deuxième zones dédiées,
- la deuxième électrode de la mémoire ferroélectrique étant formée par un tri-couche comportant dans la deuxième zone dédiée, une première couche conductrice en contact avec la couche active, une deuxième couche conductrice sur la première couche conductrice et une troisième couche conductrice sur la deuxième couche conductrice,
- la deuxième électrode de la mémoire résistive OxRAM étant formée par un bi-couche comportant dans la première zone dédiée, la deuxième couche conductrice en contact avec la couche active et la troisième couche conductrice sur la première couche conductrice,
- le matériau de la seconde couche conductrice étant choisi pour créer des lacunes d'oxygène dans la couche active de la mémoire résistive OxRAM lorsque la seconde couche conductrice est en contact avec la couche active de la mémoire résistive OxRAM.

8. Dispositif selon la revendication 7 **caractérisé en ce que** l'épaisseur de la couche active et/ou l'épaisseur de la deuxième couche conductrice est comprise entre 3nm et 15nm.

9. Dispositif selon l'une des revendications 7 à 8 **caractérisé en ce que** l'épaisseur de la troisième couche conductrice est comprise entre 20nm et 200nm.

10. Dispositif selon l'une des revendications 7 à 9 **caractérisé en ce que** la mémoire ferroélectrique comporte une cuvette présentant une paroi interne sur laquelle sont successivement agencée la couche de première électrode, la couches de matériau actif à base de dioxyde d'hafnium, le tri-couche comportant la première couche conductrice, la deuxième couche conductrice et la troisième couche conductrice sur la deuxième couche conductrice.

11. Procédé d'entrainement et d'inférence d'un système d'intelligence artificielle comportant un dispositif selon l'une des revendications 7 à 10 **caractérisé en ce que** la mémoire ferroélectrique est utilisée lors des phases d'entraînement et la mémoire résistive OxRAM est utilisée lors des phases d'inférence.

## Patentansprüche

1. Verfahren (100, 100') zur gemeinsamen Herstellung eines ferroelektrischen Speichers mit einer ersten Elektrode, einer zweiten Elektrode und einer Schicht aus aktivem Material auf Hafniumdioxidbasis, die zwischen der ersten Elektrode und der zweiten Elektrode angeordnet ist, und eines resistiven OxRAM-Speichers mit einer ersten Elektrode, einer zweiten Elektrode und einer Schicht aus aktivem Material auf Hafniumdioxidbasis, die zwischen der ersten Elektrode und der zweiten Elektrode angeordnet ist, wobei das Verfahren zur gemeinsamen Herstellung die folgenden Schritte umfasst:
- Einen Schritt des Auftragens (101, 101') einer ersten Elektrodenschicht (201, 201'), die für den Bereich (Z1), der den resistiven OxRAM-Speicher bilden soll, und den Bereich (Z2), der den ferroelektrischen Speicher bilden soll, auf identische Weise hergestellt wird;
- Einen Schritt des Auftragens (102, 102') einer Schicht aus aktivem Material auf Hafniumdioxidbasis (202, 202'), die für den Bereich (Z1), der den resistiven OxRAM-Speicher bilden soll, und den Bereich (Z2), der den ferroelektrischen Speicher bilden soll, auf identische Weise hergestellt wird;
- Einen Schritt des Auftragens (105, 105') einer ersten leitfähigen Schicht (204, 204'), die für den Bereich (Z1), der dazu bestimmt ist, den resistiven OxRAM-Speicher zu bilden, und den Bereich (Z2), der dazu bestimmt ist, den ferroelektrischen Speicher zu bilden, auf identische Weise hergestellt wird;
- Einen Schritt zum Herstellen (106, 106') einer Maske (205, 205') im Bereich (Z2) der ersten leitfähigen Schicht, der dazu bestimmt ist, den ferroelektrischen Speicher zu bilden, wobei der Bereich (Z1) der ersten leitfähigen Schicht, der dazu bestimmt ist, den resistiven OxRAM-Speicher zu bilden, frei bleibt;
- Einen Schritt des Entfernens (107, 107') der ersten leitfähigen Schicht (204, 204') im Bereich (Z1) der ersten leitfähigen Schicht, der dazu bestimmt ist, den resistiven OxRAM-Speicher zu bilden, wobei der Bereich (Z2) der ersten leitfähigen Schicht, der dazu bestimmt ist, den ferroelektrischen Speicher zu bilden, durch die Maske (205, 205') geschützt ist;
- Einen Schritt des Entfernens (108, 108') der Maske (205, 205') im Bereich (Z2) der ersten leitfähigen Schicht, der dazu bestimmt ist, den ferroelektrischen Speicher zu bilden;
- Einen Schritt des Auftragens (109, 109') einer zweiten leitfähigen Schicht (206, 206'), wobei die zweite leitfähige Schicht (206, 206') im Bereich (Z2) der ersten leitfähigen Schicht zur Bildung des ferroelektrischen Speichers mit der ersten leitfähigen Schicht (204, 204') in Kontakt steht und mit der Schicht aus aktivem Material (203, 203') im Bereich (Z1) der ersten leitfähigen Schicht zur Bildung des resistiven OxRAM-Speichers in Kontakt steht, wobei das Material der zweiten leitfähigen Schicht (206, 206') so gewählt ist, dass es in der aktiven Schicht des resistiven OxRAM-Speichers Sauerstofflücken erzeugt, wenn die zweite leitfähige Schicht mit der aktiven Schicht (203, 203') des resistiven OxRAM-Speichers in Kontakt ist;
- Einen Schritt des Auftragens (109, 109') einer dritten leitfähigen Schicht (207, 207'), die für den Bereich (Z1) zur Bildung des resistiven OxRAM-Speichers und den Bereich (Z2) zur Bildung des ferroelektrischen Speichers auf identische Weise hergestellt wird, wobei die dritte leitfähige Schicht (207, 207`) mit der zweiten leitfähigen Schicht (206, 206') in Kontakt ist.

2. Verfahren nach Anspruch 1, **dadurch gekennzeichnet, dass** der Schritt der Herstellung der Maske im Bereich der ersten leitfähigen Schicht, der dazu bestimmt ist, den ferroelektrischen Speicher zu bilden, unter Freilassung des Bereichs der ersten leitfähigen Schicht, der dazu bestimmt ist, den resistiven OxRAM-Speicher zu bilden, die folgenden Schritte umfasst:
- Einen Schritt des Auftragens einer Maske auf die erste leitfähige Schicht im Bereich der ersten leitfähigen Schicht, der den ferroelektrischen Speicher bilden soll, und im Bereich der ersten leitfähigen Schicht, der den resistiven OxRAM-Speicher bilden soll;
- Einen Schritt des Entfernens der Maske im Bereich der ersten leitfähigen Schicht, der den resistiven OxRAM-Speicher bilden soll, wobei die Maske im Bereich der ersten leitfähigen Schicht, der den ferroelektrischen Speicher bilden soll, zurückbleibt.

3. Verfahren nach einem der vorhergehenden Ansprüche, **dadurch gekennzeichnet, dass** es im Anschluss an den Schritt des Auftragens (102, 102') der Schicht aus aktivem Material auf Hafniumdioxidbasis (202, 202') einen Dotierungsschritt (103, 103') der Schicht aus aktivem Material (202, 202') umfasst, der für den Bereich (Z1), der dazu bestimmt ist, den resistiven OxRAM-Speicher zu bilden, und den Bereich (Z2), der dazu bestimmt ist, den ferroelektrischen Speicher zu bilden, auf identische Weise durchgeführt wird.

4. Verfahren nach dem vorhergehenden Anspruch, **dadurch gekennzeichnet, dass** der Dotierungsschritt durch Ionenimplantation oder mit Hilfe eines Dotierungsvorläufers oder durch Co-Sputtering durchgeführt wird.

5. Verfahren nach einem der Ansprüche 3 oder 4, **dadurch gekennzeichnet, dass** das Dotierungselement, das für den Dotierungsschritt verwendet wird, aus einem der folgenden Elemente ausgewählt wird: Si, Al, Zr, Gd, Ge, Y oder N.

6. Verfahren nach einem der Ansprüche 3 bis 5, **dadurch gekennzeichnet, dass** das Dotierungselement Si ist und während des Dotierungsschritts die Schicht aus aktivem Material einer Dotierungsdosis zwischen 10¹⁴ Ionen/cm² und 5.10¹⁴ Ionen/cm² ausgesetzt wird.

7. Vorrichtung mit einem resistiven OxRAM-Speicher in einem ersten bestimmten Bereich und einem ferroelektrischen Speicher in einem zweiten bestimmten Bereich,
- wobei der ferroelektrische Speicher eine erste Elektrode, eine zweite Elektrode und eine Schicht aus aktivem Material auf Hafniumdioxidbasis umfasst, die zwischen der ersten Elektrode und der zweiten Elektrode angeordnet ist,
- wobei der resistive OxRAM-Speicher eine erste Elektrode, eine zweite Elektrode und eine Schicht aus aktivem Material auf Hafniumdioxidbasis umfasst, die zwischen der ersten Elektrode und der zweiten Elektrode angeordnet ist,
- wobei die unteren Elektroden des ferroelektrischen und des resistiven OxRAM-Speichers durch eine gleiche Schicht einer ersten Elektrode gebildet werden, die im ersten und zweiten bestimmten Bereich vorhanden ist,
- wobei die Schichten aus aktivem Material auf Hafniumdioxidbasis des ferroelektrischen und des resistiven OxRAM-Speichers durch eine gleiche Schicht aus aktivem Material auf Hafniumdioxidbasis gebildet werden, die im ersten und zweiten bestimmten Bereich vorhanden ist,
- wobei die zweite Elektrode des ferroelektrischen Speichers durch eine Dreifachschicht gebildet wird, die im zweiten bestimmten Bereich eine erste leitfähige Schicht, die mit der aktiven Schicht in Kontakt steht, eine zweite leitfähige Schicht auf der ersten leitfähigen Schicht und eine dritte leitfähige Schicht auf der zweiten leitfähigen Schicht umfasst,
- wobei die zweite Elektrode des resistiven OxRAM-Speichers durch eine Doppelschicht gebildet wird, die im ersten bestimmten Bereich die zweite leitfähige Schicht in Kontakt mit der aktiven Schicht und die dritte leitfähige Schicht auf der ersten leitfähigen Schicht umfasst,
- wobei das Material der zweiten leitfähigen Schicht so gewählt ist, dass es in der aktiven Schicht des resistiven OxRAM-Speichers Sauerstofflücken erzeugt, wenn die zweite leitfähige Schicht mit der aktiven Schicht des resistiven OxRAM-Speichers in Kontakt ist.

8. Vorrichtung nach Anspruch 7, **dadurch gekennzeichnet, dass** die Dicke der aktiven Schicht und/oder die Dicke der zweiten leitfähigen Schicht zwischen 3 nm und 15 nm liegt.

9. Verfahren nach einem der Ansprüche 7 bis 8, **dadurch gekennzeichnet, dass** die Dicke der dritten leitfähigen Schicht zwischen 20 nm und 200 nm liegt.

10. Vorrichtung nach einem der Ansprüche 7 bis 9, **dadurch gekennzeichnet, dass** der ferroelektrische Speicher eine Wanne mit einer Innenwand umfasst, auf der nacheinander die Schicht der ersten Elektrode, die Schicht des aktiven Materials auf Hafniumdioxidbasis, die Dreifachschicht mit der ersten leitfähigen Schicht, die zweite leitfähige Schicht und die dritte leitfähige Schicht auf der zweiten leitfähigen Schicht angeordnet sind.

11. Verfahren zum Trainieren und Schlussfolgern eines Systems künstlicher Intelligenz mit einer Vorrichtung nach einem der Ansprüche 7 bis 10, **dadurch gekennzeichnet, dass** der ferroelektrische Speicher während der Trainingsphasen und der resistive OxRAM-Speicher während der Inferenzphasen verwendet werden.

## Claims

1. A method (100, 100') for co-manufacturing a ferroelectric memory comprising a first electrode, a second electrode and a layer of hafnium dioxide-based active material disposed between the first electrode and the second electrode and an OxRAM resistive memory comprising a first electrode, a second electrode and a layer of hafnium dioxide-based active material disposed between the first electrode and the second electrode, the co-manufacturing method including the following steps:
- A step of depositing (101, 101') a layer of first electrode (201, 201') carried out identically for the zone (Z1) for forming the OxRAM resistive memory and the zone (Z2) for forming the ferroelectric memory;
- A step of depositing (102, 102') a layer of hafnium dioxide-based active material (202, 202') carried out identically for the zone (Z1) for forming the OxRAM resistive memory and the zone (Z2) for forming the ferroelectric memory;
- A step of depositing (105, 105') a first conductive layer (204, 204') carried out identically for the zone (Z1) for forming the OxRAM resistive memory and the zone (Z2) for forming the ferroelectric memory;
- A step of making (106, 106') a mask (205, 205') at the zone (Z2) of the first conductive layer for forming the ferroelectric memory, leaving the zone (Z1) of the first conductive layer for forming the OxRAM resistive memory free;
- A step of removing (107, 107') the first conductive layer (204, 204') at the zone (Z1) of the first conductive layer for forming the OxRAM resistive memory, the zone (Z2) of the first conductive layer for forming the ferroelectric memory being protected by the mask (205, 205');
- A step of removing (108, 108') the mask (205, 205') at the zone (Z2) of the first conductive layer for forming the ferroelectric memory;
- A step of depositing (109, 109') a second conductive layer (206, 206'), said second conductive layer (206, 206') being in contact with the first conductive layer (204, 204') at the zone (Z2) of the first conductive layer for forming the ferroelectric memory and in contact with the layer of active material (203, 203') at the zone (Z1) of the first conductive layer for forming the OxRAM, the material of the second conductive layer (206, 206') being selected to create oxygen vacancies in the active layer of the OxRAM when the second conductive layer is in contact with the active layer (203, 203') of the OxRAM;
- A step of depositing (109, 109') a third conductive layer (207, 207') carried out identically for the zone (Z1) for forming the OxRAM and the zone (Z2) for forming the ferroelectric memory, said third conductive layer (207, 207') being in contact with the second conductive layer (206, 206').

2. The method according to claim 1, **characterised in that** the step of making the mask at the zone of the first conductive layer for forming the ferroelectric memory leaving the zone of the first conductive layer for forming the OxRAM resistive memory free includes the following steps:
- A step of depositing a mask on the first conductive layer at the zone of the first conductive layer for forming the ferroelectric memory and the zone of the first conductive layer for forming the OxRAM resistive memory;
- A step of removing the mask at the zone of the first conductive layer for forming the OxRAM resistive memory while leaving the mask at the zone of the first conductive layer for forming the ferroelectric memory.

3. The method according to one of the preceding claims, **characterised in that** it includes, at the end of the step of depositing (102, 102') the layer of hafnium dioxide-based active material (202, 202'), a step of doping (103, 103') the layer of active material (202, 202') carried out identically for the zone (Z1) for forming the OxRAM resistive memory and the zone (Z2) for forming the ferroelectric memory.

4. The method according to the preceding claim, **characterised in that** the doping step is carried out by ion implantation or using a doping precursor or by co-sputtering.

5. The method according to any of claims 3 or 4, **characterised in that** the dopant element used for the doping step is selected from one of the following elements: Si, Al, Zr, Gd, Ge, Y or N.

6. The method according to any of claims 3 to 5, **characterised in that** the dopant element is Si and, during the doping step, the layer of active material is exposed to a dopant dose of between 10¹⁴ ions/cm² and 5.10¹⁴ ions/cm².

7. A device including an OxRAM resistive memory arranged in a first dedicated zone and a ferroelectric memory arranged in a second dedicated zone,
- the ferroelectric memory including a first electrode, a second electrode and a layer of hafnium dioxide-based active material disposed between the first electrode and the second electrode,
- the OxRAM resistive memory including a first electrode, a second electrode and a layer of hafnium dioxide-based active material disposed between the first electrode and the second electrode,
- the bottom electrodes of the OxRAM ferroelectric and resistive memories being formed by a same layer of first electrode present on the first and second dedicated zones,
- the layers of hafnium dioxide-based active materials of the OxRAM ferroelectric and resistive memories being formed by a same layer of hafnium dioxide-based active material present on the first and second dedicated zones,
- the second electrode of the ferroelectric memory being formed by a tri-layer including, in the second dedicated zone, a first conductive layer in contact with the active layer, a second conductive layer on the first conductive layer and a third conductive layer on the second conductive layer,
- the second electrode of the resistive OxRAM being formed by a bi-layer including the second conductive layer in contact with the active layer and the third conductive layer on the first conductive layer, in the first dedicated zone,
- the material of the second conductive layer being selected to create oxygen vacancies in the active layer of the OxRAM resistive memory when the second conductive layer is in contact with the active layer of the OxRAM resistive memory.

8. The device according to claim 7, **characterised in that** the thickness of the active layer and/or the thickness of the second conductive layer is between 3nm and 15nm.

9. A device according to one of claims 7 to 8, **characterised in that** the thickness of the third conductive layer is between 20nm and 200nm.

10. A device according to one of claims 7 to 9, **characterised in that** the ferroelectric memory includes a pit having an inner wall on which the layer of first electrode, the layer of hafnium dioxide-based active material, the tri-layer including the first conductive layer, the second conductive layer and the third conductive layer on the second conductive layer are successively arranged.

11. A method for training and inferring an artificial intelligence system including a device according to any of claims 7 to 10, **characterised in that** the ferroelectric memory is used in training phases and the OxRAM resistive memory is used in inference phases.
